# EUROPEAN PATENT APPLICATION

(11) **EP 2 587 534 A2**
(43) Date of publication of application: **01.05.2013**
(21) Application number: 11798322.1
(22) Date of filing: 27.05.2011
(51) Int. Cl.: H01L 23/34, H01L 33/64

(54) **COOLING DEVICE FOR A HEAT-EMITTING ELEMENT**

(30) Priority: 23.06.2010 KR 20100059477; 22.06.2010 KR 20100059309; 22.06.2010 KR 20100059314; 22.06.2010 KR 20100059313; 22.06.2010 KR 20100059312
(71) Applicant: Young Dong Tech Co., Ltd, Changwon, Gyeongsangnam-Do 641-050 (KR)
(72) Inventor: YOON, Chanheon, Gimhae-si Gyeongsangnam-Do 621-707 (KR)
(74) Representative: Colombo, Michel
(86) International application number: PCT/KR2011/003891
(87) International publication number: WO 2011/162487

(57) **Abstract**

The present invention relates to a heat sink apparatus used for an exothermic element generating heat during an operation.

A heat sink apparatus for an exothermic element according to the invention includes a first copper heat plate for accumulating heat of an exothermic element, a copper heat path for conducting the accumulated heat in an extended direction of the copper heat path, a second copper heat plate for dispersing the conducted heat, and a heat fin for discharging the accumulated or discharged heat to the outside. One surface of the first copper heat plate is in close contact with the exothermic element. The copper heat path extends from the other surface of the first copper heat plate. One surface of the second copper heat plate is spaced apart from the other surface of the first copper heat plate and the second copper heat plate includes a supporting hole. The supporting hole is in close contact with and supporting the copper heat path. The heat fin is formed at the other surface of the first copper heat plate and the other surface of the second copper heat plate.

According to the heat sink apparatus for the exothermic element of the invention can maximize cooling efficiency through a simple structure.

## Description

Technical Field

The present invention relates to a heat sink apparatus used for an exothermic element (such as a light emitting diode (LED) device and an exothermic element for information technology (IT)) generating heat during an operation,.

Backgroudn Art

Generally, electronic elements (such as a resistor, an inductor, a capacitor, a semiconductor, and so on) constituting electronics generate heat of high temperature because they converts a part of electric energy to heat energy during an operation, thereby generating heat of high temperature. The electronics may does not work well due to the heat of the electronic elements. Seriously, the electronics may be broken. Thus, various heat sink apparatus (such as, a radiation plate, a radiation fin, a radiation fan(or a cooling fan), an so on) for cooling an exothermic element are used. Also, research and development for enhancing cooling efficiency continue.

On the other hand, in recent times, as an LED(light emitting diode) device is greatly developed and widely used, an LED light replaces a lamp, a bulb, or a light (such as an incandescent light, a fluorescent light, and the like). Also, application fields of the LED light are on the gradual increase. The LED device is also a semiconductor element, and generates a lot of heat during an operation.

Technical Problem

The invention is provided to solve the above problems. The invention is to provide a heat sink apparatus for an exothermic element being able to effectively cool the exothermic element or radiate the heat of the exothermic element.

Also, the invention is to provide a heat sink apparatus for a light emitting diode(LED) light using an LED device, which use expands, among exothermic elements.

The technical problems to be solved of the invention are not limited to the above technical problems to be solved. Other unmentioned technical problems to be solved of the invention can be clearly understood from the following descriptions by skilled person in the art to which the invention pertains.

Technical Solution

A heat sink apparatus for an exothermic element according to the invention includes a first copper heat plate for accumulating heat of an exothermic element, a copper heat path for conducting the accumulated heat in an extended direction of the copper heat path, a second copper heat plate for dispersing the conducted heat, and a heat fin for discharging the accumulated or discharged heat to the outside. One surface of the first copper heat plate is in close contact with the exothermic element. The copper heat path extends from the other surface of the first copper heat plate. One surface of the second copper heat plate is spaced apart from the other surface of the first copper heat plate and the second copper heat plate includes a supporting hole. The supporting hole is in close contact with and supporting the copper heat path. The heat fin is formed at the other surface of the first copper heat plate and the other surface of the second copper heat plate.

Also, according to the invention, the heat sink apparatus for the exothermic element further includes a third copper heat plate partially or entirelly seals side surfaces of the first copper heat plate, the second copper heat plate, and the heat fin.

In addition, according to the invention, the heat sink apparatus for the exothermic element further includes at least one copper heat coil. One end of the copper heat coil is connected to the extended end of the copper heat path or the other surface of the second copper heat plate. The copper heat coil is wound from the one end to the other end without contacting. The copper heat coil conducts the accumulated or discharged heat to the other end, vibrates by a temperature difference with the atmosphere, and discharges the heat to the outside by forced convection.

Further, according to the invention, the copper heat coil has a wound coil shape or a wound plate shape.

Furthermore, according to the invention, the heat sink apparatus for the exothermic element further includes a fourth copper heat plate extended from the first copper heat plate to form side surfaces and an upper surface, wherein the fourth copper heat plate makes an airtight inner space where a coolant is positioned; and a copper heat fin formed at an outer surface of the copper heat path being in contact with the coolant and conducting the conducted heat from the copper heat path to the coolant.

Also, according to the invention, the coolant is antifreeze.

In addition, according to the invention, the copper heat path has a pipe shape having at least a pair of ends connected to each other and being filled with the coolant.

Further, according to the invention, the sink apparatus for the exothermic element further includes a low-speed cooling fan installed at one side of a heat block the first copper heat plate, the copper heat path, the second copper heat plate, and the heat fin, wherein the low-speed cooling fan forced-convecting the atmosphere and eliminating dust of the heat block during an operation having an operation time of 25,000 hours or more; and a thermostat detecting temperature of the heat block, wherein the thermostat operating the low-speed cooling fan when the temperature is the predetermined threshold temperature or more and stopping the low-speed cooling fan when the temperature is less than the predetermined threshold temperature.

Furthermore, according to the invention, the copper heat path has one of a pipe shape, a plate shape, a polygonal stick shape, or a coil shape.

Also, according to the invention, the second copper heat plate includes at least two second copper heat plates spaced apart from each other in the extended direction of the copper heat path. The heat fin includes at least two heat fins formed at the at least two second copper heat plates, respectively.

In addition, according to the invention, the heat fin includes an aluminum material and a mixture material of aluminum and copper.

Further, according to the invention, the heat fin includes a plate-shape fin or a corrugated fin.

Furthermore, according to the invention, the heat sink apparatus for the exothermic element further includes an alumunum case supporting the first copper heat plate, the copper heat path, the second copper heat plate, and the heat fin. The aluminum case has an oepn type or a close type.

Also, according to the invention, the exothermic element is at least one of a light emitting diode (LED) device or an exothermic element for information technology (IT).

In addition, according to the invention, the heat sink apparatus for the exothermic element further includes an aluminum LED cover fixing and supporting the LED device, and a synthetic-resin LED cover surrounding the LED device to be an outermost cover and protecting the LED device.

Another heat sink apparatus for an exothermic element according to the invention includes a first heat plate for accumulating heat of an exothermic element, a heat path for conducting the accumulated heat in an extended direction of the heat path, a second heat plate for dispersing the conducted heat, and a heat fin for discharging the accumulated or discharged heat to the outside. One surface of the first heat plate is in close contact with the exothermic element and the first heat plate includes a first metal material. The heat path extends from the other surface of the first heat plate and the heat path including the first metal material. One surface of the second heat plate is spaced apart from the other surface of the first heat plate and the second heat plate includes a supporting hole. The supporting hole is in close contact with and supports the heat path. The second heat plate includes the first metal material. The heat fin is formed at the other surface of the first heat plate and the other surface of the second heat plate. The heat fin includes a second metal material having heat-radiating efficiency higher than that of the first metal material.

Also, according to the invention, the second metal material includes an aluminum material and a mixture material of aluminum and copper. The first metal material includes gold, silver, or copper having thermal conductivity and heat-accumulating property superior than those of the second metal material.

Advantageous Effects

By the technical solutions, a heat sink apparatus for an exothermic element according to the invention can maximize the cooling efficiency using a simple structure.

Also, in the heat sink apparatus for the exothermic element according to the first embodiment of the invention, a structure can be easily changed according to the heat amount from the exothermic element, and thus, the cooling efficiency can be controlled.

The heat sink apparatus for the LED device according to the invention as in the above can compose a portable LED light being interal with the heat sink apparatus and having high cooling efficiency.

Description of Drawings

FIG. 1 is a schematic view illustrating a basic structure of a heat sink apparatus for an exothermic element according to a first embodiment of the invention.

FIG. 2 is a schematic view illustrating another heat sink apparatus for an exothermic element according to the first embodiment of the invention.

FIG. 3 is a perspective view of a heat sink apparatus for an LED device according to the first embodiment of the invention.

FIG. 4 is a perspective view of a heat sink apparatus for an LED device in the state that a synthetic-resin LED cover is eliminated, according to the first embodiment of the invention.

FIG. 5 is a cross-sectional view the heat sink apparatus for the LED device according to the first embodiment of the invention.

FIG. 6 is a schematic view illustrating a basic structure of a heat sink apparatus for an exothermic element according to a second embodiment of the invention.

FIG. 7 is a schematic view illustrating a heat block structure of the heat sink apparatus for the exothermic element according to the second embodiment of the invention.

FIG. 8 is a perspective view of a heat sink apparatus for an LED device according to the second embodiment of the invention.

FIG. 9 is a perspective view of the heat sink apparatus for the LED device in the state that a synthetic-resin LED cover is eliminated, according to the second embodiment of the invention.

FIG. 10 is a cross-sectional view the heat sink apparatus for the LED device according to the second embodiment of the invention.

FIG. 11 is a schematic view illustrating a basic structure of a heat sink apparatus for an exothermic element according to a third embodiment of the invention.

FIG. 12 is a schematic view illustrating another heat sink apparatus for an exothermic element according to the third embodiment of the invention.

FIG. 13 is a perspective view of a heat sink apparatus for an LED device according to the third embodiment of the invention.

FIG. 14 is a perspective view of the heat sink apparatus for the LED device in the state that a synthetic-resin LED cover is eliminated, according to the third embodiment of the invention.

FIG. 15 is a cross-sectional view the heat sink apparatus for the LED device according to the third embodiment of the invention.

FIG. 16 is a schematic view illustrating a basic structure of a heat sink apparatus for an exothermic element according to a fourth embodiment of the invention.

FIG. 17 is a schematic view illustrating another heat sink apparatus for an exothermic element according to the fourth embodiment of the invention.

FIG. 18 is a schematic view illustrating yet another heat sink apparatus for an exothermic element according to the fourth embodiment of the invention.

FIG. 19 is a perspective view of a heat sink apparatus for an LED device according to the fourth embodiment of the invention.

FIG. 20 is a perspective view of the heat sink apparatus for the LED device in the state that a synthetic-resin LED cover is eliminated, according to the fourth embodiment of the invention.

FIG. 21 is a cross-sectional view the heat sink apparatus for the LED device according to the fourth embodiment of the invention.

FIG. 22 is a schematic view illustrating a basic structure of a heat sink apparatus for an exothermic element according to a fifth embodiment of the invention.

FIG. 23 is a schematic view illustrating a heat sink apparatus for an exothermic element according to anther embodiment of the invention.

<Descriptions of reference numerals of drawings>

10 : an exothermic element

20 : an LED device

110, 210, 311, 411, 511, 711, 811 : a first copper heat plate

120, 220, 312, 412, 520, 620, 712, 812, 920 : a copper heat path

130, 130a, 130b, 230, 313, 313b, 413, 550, 650, 713, 813 : a second copper heat plate

131, 315, 551 : a supporting hole

140, 140a, 140b, 140c, 240, 314, 414, 714, 814, 930, 930a, 930b, 930c : a heat fin

150 : a third copper heat plate

200, 400, 600, 800 : an LED light

250, 430, 680, 850 : an aluminum case

260, 440, 690, 860 : an aluminum LED cover

270, 270a, 270b, 450, 695, 870 : a synthetic-resin LED cover

310, 410, 510, 610, 710, 810 : a heat block

320, 420, 570, 670, 740, 840 : a copper heat coil

510a, 520a, 610a, 750a : a coolant

512, 716 : a fourth copper heat plate

530, 630, 717 : a copper heat fin

540, 560, 640, 660 : an aluminum heat fin

720, 820 : a low-speed cooling fan

730, 830 : a thermostat

910 : a copper heat plate

Detailed Description of Embodiments

Specific details with respect to the above technical problems to be solved, technical solutions, and advantageous effects of the invention will be included the following embodiments and drawings. Advantages, features, and methods for achieving them of the invention will be clarified with reference to the following embodiments that will be described later in detail, along with accompanying drawings.

Hereinafter, with reference to drawings, the invention will be described in more detail.

<First Embodiment>

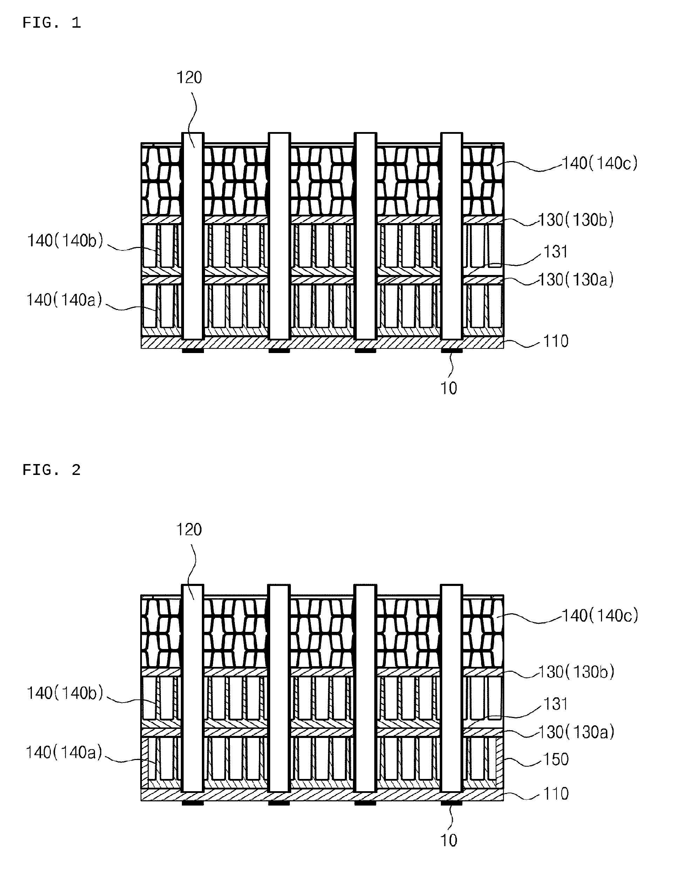

FIG. 1 is a schematic view illustrating a basic structure of a heat sink apparatus for an exothermic element according to a first embodiment of the invention.

As shown in FIG. 1, a heat sink apparatus for an exothermic element according to a first embodiment of the invention includes a first copper heat plate 110, a copper heat path (or copper heat paths) 120, a second copper heat plate (or second copper heat plates) 130, and a heat fin (of heat fins) 140. One surface of the first copper heat plate 110 is in close contact with an exothermic element 10. The first copper heat plate 110 accumulates the heat of the exothermic element 10. The copper heat path 120 extends from the other surface of the first copper heat plate 110 and conducts the accumulated heat in an extended direction of the copper heat path 120. One surface of the second copper heat plate 130 is spaced apart from the other surface of the first copper heat plate 110, and the second copper heat plate 130 includes a supporting hole (or supporting holes) 131 being in close contact with and supporting the copper heat path 120. The second copper heat plate 130 disperses the conducted heat. The heat fins 140 are formed at the other surface of the first copper heat plate 110 and the other surface of the second copper heat plate 130. The heat fin 140 discharges the accumulated or discharged heat to the outside.

That is, in the first embodiment of the invention, the copper that is not generally used for a cooling material is inversely used. The copper is not generally used for the cooling material due to a strong heat-accumulating property although the copper has thermal conductivity of about 384W/mK higher than thermal conductivity of aluminum of about 202W/mK. That is, the heat of the exothermic element 10 is immediately absorbed and accumulated, is conducted along a path at high speed, and is spreaded evenly to a copper structure. The spreaded heat is discharged to the outside by an aluminum structure. Accordingly, cooling efficiency can be effectively enhanced, compared to the conventional heat sink apparatus.

Specifically, the heat sink apparatus for the exothermic element according to the first embodiment of the invention uses a copper material and an aluminum material for discharging the heat from the exothermic element 10. The copper materials has high thermal conductivity, and the aluminum material has good thermal conductivity and good heat-radiating ability. Thus, cooling power through conduction, convection, radiation of the heat can be effectively utilized. That is, the first copper heat plate 110, the copper heat path 120, and the second copper heat plate 130 having superior thermal conductivity and superior heat-accumulating property are used together with the heat fin 140 having superior heat-radiatin efficiency.

One heat block is composed of the first copper heat plate 110, the copper heat path 120, the second copper heat plate 130, and the heat fin 140. In the heat block, the heat generated from the exothermic element 10 is immediately absorbed by the first copper heat plate 110, is conducted through the copper heat path 120 in the extended direction of the copper heat path 120 (an upward direction of FIG. 1), is transferred to the second copper heat plate 130, and is disharged. In the first embodiment, the principal that pressure and temperature decrease when liquid flowing a narrow pipe is discharged to a brod pipe is applied. Since the second copper heat plate 130 has a cross section larger than that of the copper heat path 120, the heat conducted through the copper heat path 120 having a small area is widely discharged by the second copper heat plate 130, and it induces the cooling effect to some degree. However, the copper heat path 120 may have one of a pipe shape, a plate shape, a polygonal stick shape, or a coil shape, considering the difficulty level of manufacturing or necessity needs. That is, various shapes and forming a heat path of the copper material may be applied.

Meanwhile, the accumulated or dispersed heat is discharged to the outside though the heat fins 140 formed at each of the first copper heat plate 110 and the second copper heat plate 130. The heat fin 140 may be formed of the aluminum material having superior heat-radiating efficiency as in the above. Alternatively, the heat fin 140 may be formed of a mixure material of the aluminum and the copper when more thermal conductivity is necessary. Also, the heat fins 140 according to the first embodiment of the invention may be plate-shape fins 140a and 140b or a corrugated fin 140c, as necessary. The fin 140c may be positioned to form an uppermost layer because the thickness of the corrugated fin 140c can be freely controlled according to a stacking number and the corrugated fin 140c has elasticity and an impact-resistant property.

In addition, in the first embodiment of the invention, at least two second copper heat plates 130a and 130b are spaced apart from each other in the extended direction of the copper heat path 120. The heat fins 140a, 140b, and 140c are formed at the first copper heat plate 110 and the second copper heat plates 130a and 130b, respectively. That is, regarding the exothermic element 10 generating heat of high temperature, by forming the copper heat path 120 that is a heat path lengthily and continuously and by alternatively stacking the second copper heat plates 130 and the heat fins 140, the heat generated from the exothermic element 10 can be conducted far and the cooling can be sufficient due to repitation of dispersion and discharge of the heat.

Therefore, the heat sink apparatus for the exothermic element according to the first embodiment of the invention can maximize cooling efficiency of the exothermic elements (for example, electronic devices such as a resistor, an inductor, a capacitor, a semiconductor composing electronics such as a computer and a display device). Also, in the heat sink apparatus for the exothermic element according to the first embodiment of the invention, a stacked structure can be easily changed according to the heat amount from the exothermic element, and thus, the cooling efficiency can be controlled.

FIG. 2 is a schematic view illustrating another heat sink apparatus for an exothermic element according to the first embodiment of the invention.

As shown in FIG. 2, another heat sink apparatus for an exothermic element according to the first embodiment of the invention may further include a third copper heat plate 150 partially or entirelly seals side surfaces of the first copper heat plate, the second copper heat plate, and the heat fin, along with elements of the heat sink apparatus for the exothermic element according to the first embodiment of the invention shown in FIG. 1.

That is, as shown in FIG. 1, the heat sink apparatus for the exothermic element may have an open type without the third copper heat plate 150. Alternatively, as shown in FIG. 2, the third copper heat plate 150 surroundes side surfaces of a space between the first copper heat plate 110 and the lower second copper heat plate 130a, thereby making a partial sealing. In addition, alternatively, the third copper heat plate 150 may be also formed upto the side surfaces of the uppermost heat fin 140c, and the heat sink apparatus for the exothermic element may have a close type. In this instance, the second copper heat plate 130 may be further stacked on an upper surface of the uppermost heat fin 140c, thereby enhance airtightness.

Accordingly, the intrusion of foreign substances can be prevented by the entire or partial sealing. Thus, the heat sink apparatus for the exothermic element can be used even in an environment having lots of the foreign substances such as dust.

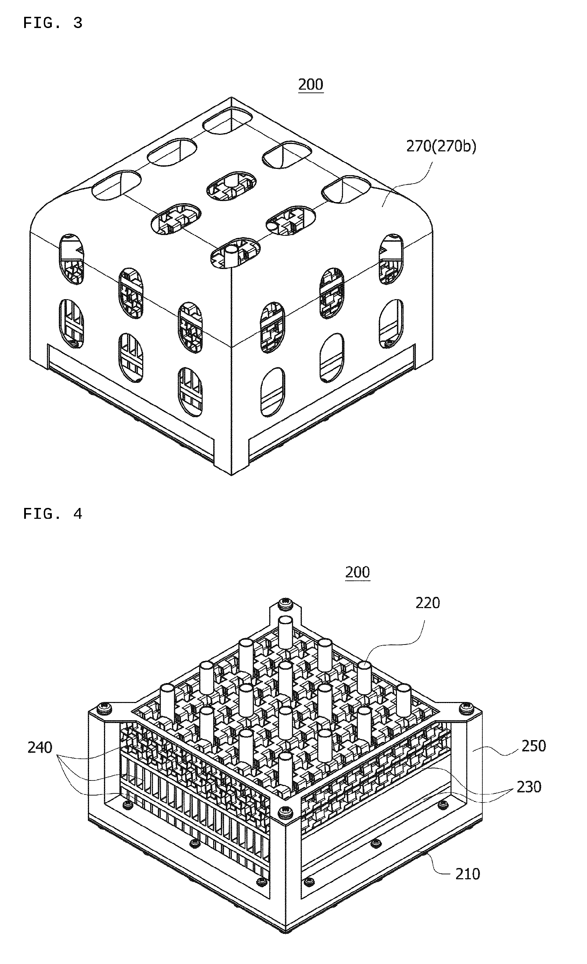

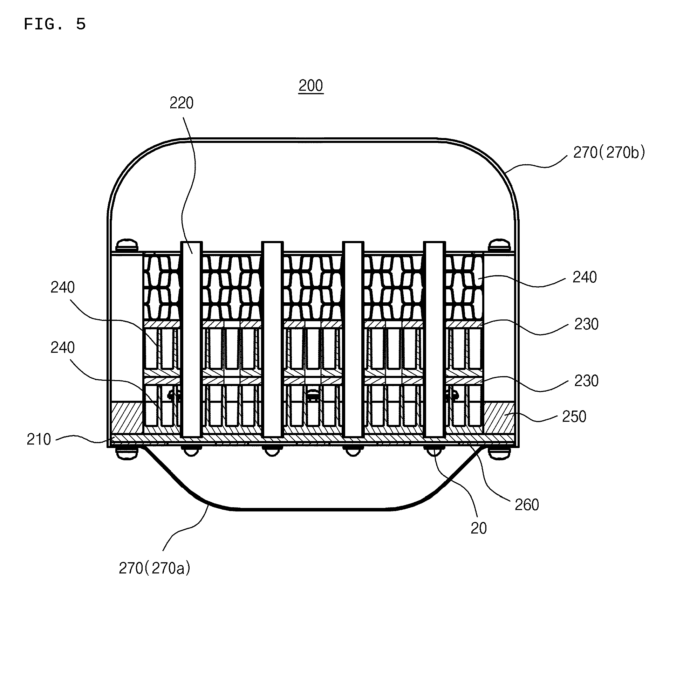

FIG. 3 to FIG. 5 illustrate a heat sink apparatus for an LED device as an example of heat sink apparatuses for exothermic elements according to the first embodiment of the invention. Specifically, FIG. 3 is a perspective view of the heat sink apparatus for the LED device according to the first embodiment of the invention. FIG. 4 is a perspective view of the heat sink apparatus for the LED device in the state that a synthetic-resin LED cover is eliminated, according to the first embodiment of the invention. FIG. 5 is a cross-sectional view the heat sink apparatus for the LED device according to the first embodiment of the invention.

As shown in FIG. 3 to FIG. 5, the heat sink apparatus for the LED device according to the first embodiment of the invention includes a first copper heat plate 210, a copper heat path (or copper heat paths) 220, a second copper heat plate (or second copper heat plates) 230, a heat fin (or heat fins) 240, an aluminum case 250, an aluminum LED cover 260, and a synthetic-resin LED cover 270. The heat sink apparatus for the LED device combined with an LED device 20 composes an LED light 200.

In this instance, the heat sink apparatus for the LED device according to the first embodiment of the invention fundamentally includes the first copper heat plate 210, the copper heat path 220, the second copper heat plate 230, and the heat fin 240, and thus, immediately absorbes and accumulates heat, and conducts and disperses the heat along a path at high speed. The spreaded heat is discharged to the outside by the heat fin 240. Accordingly, cooling efficiency can be effecctively enhanced, compared to the conventional heat sink apparatus. The second copper heat plates 230 and the heat fins 240 may be alternatively stacked as necessary. Detailed descriptions of the first copper heat plate 210, the copper heat path 220, the second copper heat plate 230, and the heat fin 240 may be referred to in the detailed descriptions in the heat sink apparatus for the exothermic element according to the first embodiment of the invention described with reference to FIG 1. Thus, the detailed descriptions thereof will be omitted.

The aluminum case 250 is formed at outer portion of a stacked structure of the first copper heat plate 210, the copper heat path 220, the second copper heat plate 230, and the heat fin 240, and fixs and supports to them. Accordingly, the heat sink apparatus for the LED device can be sturdy and solid. Also, the aluminum case 250 includes an aluminum material, and thus, a part of the heat can be conducted to the aluminum case 250 at portions where the first copper heat plate 210, the copper heat path 220, the second copper heat plate 230, and the heat fin 240 are in contact. Thus, the aluminum case 250 can discharge heat to the outside. In addition, as shown in FIG. 3 to FIG. 5, a lower portion and side surfaces of the aluminum case 250 are eliminated except for corners, and thus, the aluminum case 250 may have an open type. Thus, the convection with the outer air can be easy and the cooling efficiency can be enhanced. To the contrary, the aluminum case may have a close type as necessary. For example, the aluminum case having the close type is manufactured and used in the environment having lots of foreign substances such as dust.

Further, the heat sink apparatus for the LED device according to the first embodiment of the invention may further include the aluminum LED cover 260 and the synthetic-resin LED cover 270.

The aluminum LED cover 260 fixs and supports the LED device 20. The aluminum LED cover 260 has a plate shape, and is in close contact with one surface of the first copper heat plate 210. Also, a supporting hole(or supporting holes) is formed for fixing and supporting the LED device 20. In this instance, the LED device 20 combined with a metal printed circuit board (PCB) having a rectangular shape is in close contact with one surface of the first copper heat plate 210. Thus, the supporting hole may preferably have a shape a long hole to form a rectangle. Also, the aluminum LED cover 260 includes an aluminum material, and thus, discharges a part of the heat conducted from the first copper heat plate 210, thereby increasing the cooling efficiency.

The synthetic-resin LED cover 270 surrounds the LED device and the heat sink apparatus for the LED device to be an outermost cover and protects the LED device and the heat sink apparatus for the LED device. That is, the synthetic-resin LED cover 270 is composed of a first synthetic-resin LED cover 270a and a second synthetic-resin LED cover 270b. The first synthetic-resin LED cover 270a has a transparent material to protect the LED device 20 and to emit LED light. The second synthetic-resin LED cover 270b protects elements of the heat sink apparatus for the LED device. The second synthetic-resin LED cover 270b may have an open type or a close type, silimar to the aluminum case 250. FIG. 3 to FIG. 5 illustrate the second synthetic-resin cover 270b having the open type as an example. The synthetic-resin LED cover 270 is formed of a polycarbonate resin and so on that is easy to be injection-molded.

The heat sink apparatus for the LED device according to the first embodiment of the invention as in the above can compose a portable LED light being interal with the heat sink apparatus and having high cooling efficiency.

<Second Embodiment>

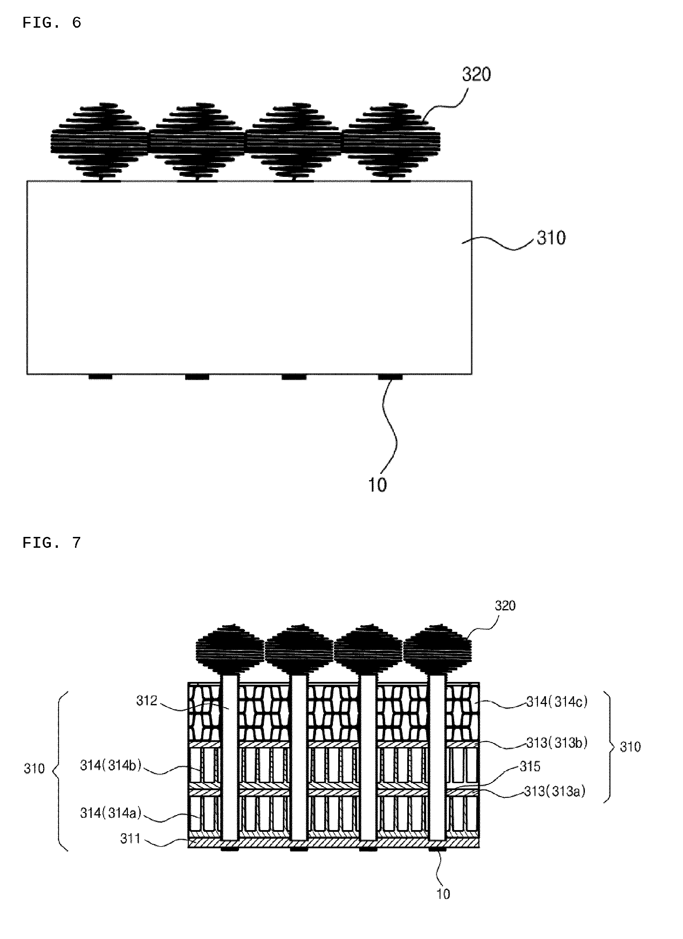

FIG. 6 is a schematic view illustrating a basic structure of a heat sink apparatus for an exothermic element according to a second embodiment of the invention.

As shown in FIG. 6, the heat sink apparatus for the exothermic element according to the second embodiment of the invention includes a heat block 310 and a copper heat coil (or copper heat coils) 320. The heat block 310 is in close contact with the exothermic element 10 and accumulates heat of the exothermic element 10. One end of the copper heat coil 320 is connected to the heat block 310, and is wound from the one end to the other end without contacting. The copper heat coil 320 conducts the accumulated or discharged heat to the other end, vibrates by a temperature difference with the atmosphere, and discharges the heat to the outside by forced convection.

In the heat sink apparatus for the exothermic element according to the second embodiment of the invention, the copper heat coil 320 is manufactured by using the copper material having superior thermal conductivity and heat-accumulating property and is in contact with the heat block 310. The copper heat coil 320 is wound to the other end without contacting, and thus, substantially forms a very long heat transfer path. Therefore, the accumulated heat is conducted to the other end of the copper heat coil 320 far away and is discharged.

Furthermore, the copper heat coil 320 vibrates even when minute heat flows by a temperature difference between the heat conducted from the heat block 310 and the atmosphere. Accordingly, the cooling power or the cooling ability can increase. In this instance, the principal that, when the heated long stick or bar is shaked in the atmosphere, the stick or bar is cooled through forced convection by friction with the atmosphere itself is applied. That is, the cooling power or the cooling ability of the copper heat coil 320 discharging the heat to the outside can be increased by the forced convection by the vibrations and the convection of the atmosphere itself. Meanwhile, the copper heat coil 320 according to the second embodiment of the invention may have a wound coil shape or a wound plate shape, considering the difficulty level of manufacturing or necessity needs. That is, various shapes forming a heat path of the copper material may be applied.

In this instance, the heat block 310 accumulates the heat of the exothermic element 10 and conducts the heat to the copper heat coil 320. The heat block 310 has a structure of the heat sink apparatus for the exothermic element according to the second embodiment shown in FIG. 7 so that the heat is dispersed and discharged to the outside.

FIG. 7 is a schematic view illustrating a heat block structure of the heat sink apparatus for the exothermic element according to the second embodiment of the invention.

As shown in FIG. 7, the heat block 310 according to the second embodiment of the invention includes a first copper heat plate 311, a copper heat path (or copper heat paths) 312, a second copper heat plate (or second copper heat plates) 313, and a heat fin (or heat fins) 314. One surface of the first copper heat plate 311 is in close contact with an exothermic element 10. The first copper heat plate 311 accumulates the heat of the exothermic element 10. The copper heat path 312 extends from the other surface of the first copper heat plate 311 and conducts the accumulated heat in an extended direction of the copper heat path 312. One surface of the second copper heat plate 313 is spaced apart from the other surface of the first copper heat plate 311, and the second copper heat plate 313 includes a supporting hole (or supporting holes) 315 being in close contact with and supporting the copper heat path 312. The second copper heat plate 313 disperses the conducted heat. The heat fins 314 are formed at the other surface of the first copper heat plate 311 and the other surface of the second copper heat plate 313. The heat fins 314 discharge the accumulated or discharged heat to the outside.

The copper heat coil 320 according to the second embodiment of the invention may be installed at the extended end of the copper heat path 312. Also, the copper heat coil 320 may be installed at the uppermost second copper heat plate 313b by extending a connected end of the copper heat coil 320 upto the other surface of the second copper heat plate 313b.

Detailed descriptions of the first copper heat plate 311, the copper heat path 312, the second copper heat plate 313, and the heat fin 314 may be referred to in the detailed descriptions in the heat sink apparatus for the exothermic element according to the first embodiment of the invention described with reference to FIG 1 and FIG. 2. Thus, the detailed descriptions thereof will be omitted.

Therefore, the heat sink apparatus for the exothermic element according to the second embodiment of the invention can maximize cooling efficiency of the exothermic element (for example, electronic devices such as a resistor, an inductor, a capacitor, a semiconductor composing electronics such as a computer and a display device) by the copper heat coil and the heat block. Also, in the heat sink apparatus for the exothermic element according to the second embodiment of the invention, a stacked structure or a number of the copper heat coil can be easily changed according to the heat amount from the exothermic element, and thus, the cooling efficiency can be controlled.

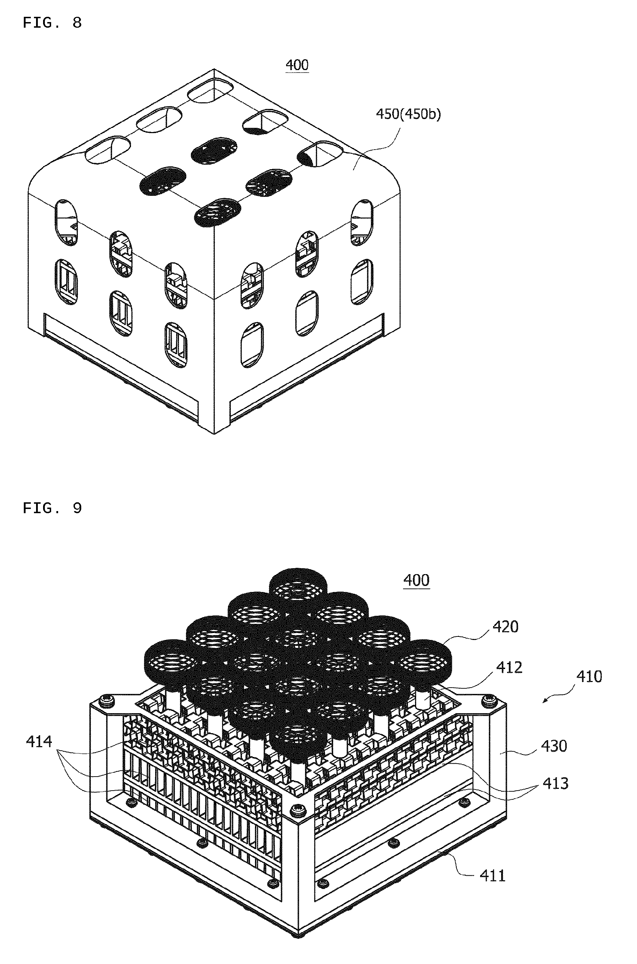

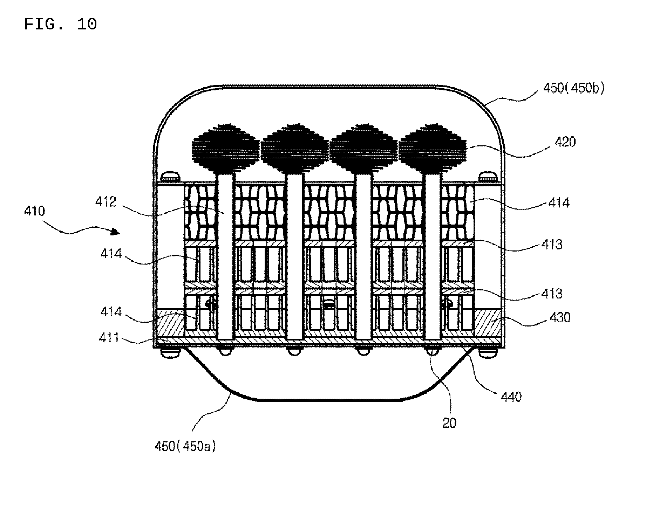

FIG. 8 to FIG. 10 illustrate a heat sink apparatus for an LED device as an example of the heat sink apparatus for the exothermic element according to the second embodiment of the invention. Specifically, FIG. 8 is a perspective view of a heat sink apparatus for an LED device according to the second embodiment of the invention. FIG. 9 is a perspective view of the heat sink apparatus for the LED device in the state that a synthetic-resin LED cover is eliminated, according to the second embodiment of the invention. FIG. 10 is a cross-sectional view the heat sink apparatus for the LED device according to the second embodiment of the invention.

As shown in FIG. 8 to FIG. 10, the heat sink apparatus for the LED device according to the second embodiment of the invention includes a heat block 410, a copper heat plate 420, an aluminum case 430, an aluminum LED cover 440, and a synthetic-resin LED cover 450. The heat sink apparatus for the LED device combined with an LED device 20 composes an LED light 400. The heat block 410 is composed of or includes a first copper heat plate 411, a copper heat path (or copper heat paths) 412, a second copper heat plate (or copper heat plates) 413, and a heat fin (or heat fins) 414.

In this instance, the heat sink apparatus for the LED device according to the second embodiment of the invention fundamentally includes the heat block 410 and the copper heat plate 420, and thus, immediately absorbes and accumulates heat, and conducts and disperses the heat along a path at high speed. The heat conducted to the copper heat coil 420 flows along a long path and is discharged to the outside by the forced-convection through vibrations. Also, the spreaded heat is discharged to the outside by the heat fin 414. Detailed descriptions of the heat block 410 and the copper heat coil 420 may be referred to in the detailed descriptions in the heat sink apparatus for the exothermic element according to the second embodiment of the invention described with reference to FIG 6 and FIG. 7. Thus, the detailed descriptions thereof will be omitted.

In addition, the heat sink apparatus for the LED device further includes the aluminum case 430, the aluminum LED cover 440, and the synthetic-resin LED cover 450, as in the first embodiment of the invention.

The heat sink apparatus for the LED device according to the second embodiment of the invention as in the above can compose a portable LED light being interal with the heat sink apparatus and having high cooling efficiency.

<Third Embodiment>

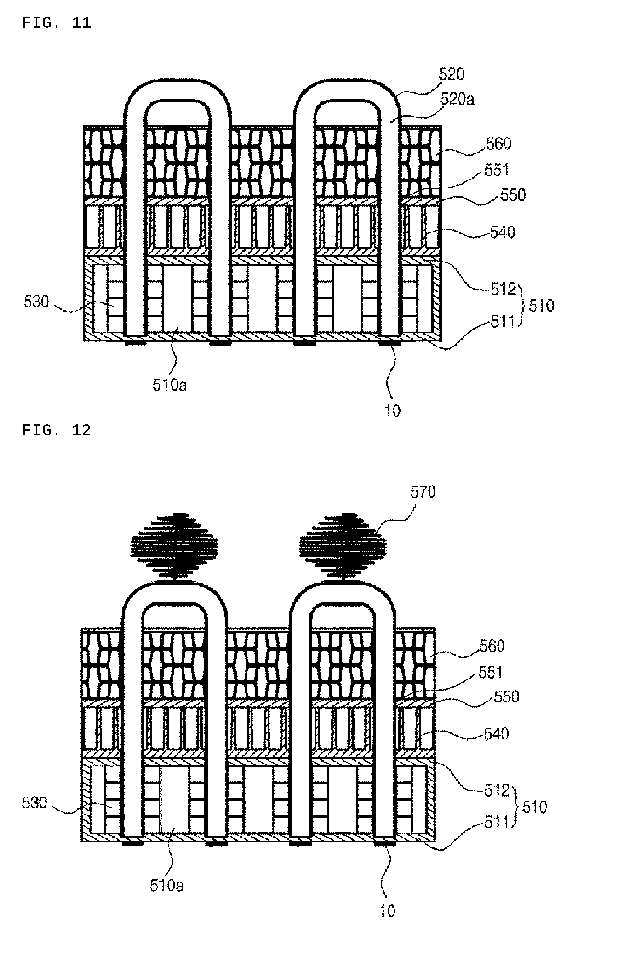

FIG. 11 is a schematic view illustrating a basic structure of a heat sink apparatus for an exothermic element according to a third embodiment of the invention.

As shown in FIG. 11, the heat sink apparatus for the exothermic element according to the third embodiment of the invention includes a copper heat block 510, a copper heat path (or copper heat paths) 520, a copper heat fin (or copper heat fins) 530, and an aluminum heat fin (or aluminum heat fins) 540. One surface of the copper heat block 510 is in close contact with an exothermic element 10. The first copper heat plate 511 accumulates the heat of the exothermic element 10 and conducts the accumulated heat to an inside coolant 510a. The copper heat path 520 extends from one surface of the copper heat block 510 and penetrates the copper heat block 510. The copper heat path 520 conducts the accumulated heat in an extended direction of the copper heat path 520. The copper heat fin 530 is formed at an outer surface of the copper heat path 520 that is located inside the copper heat block 510. The copper heat fin 530 conducts the conducted heat from the copper heat path 520 to the coolant 510a. The aluminum heat fin 540 is in close contact to the other surface of the copper heat block 510 and the copper heat path 520 penetrates the aluminum heat fin 540. The aluminum heat fin 540 discharges the accumulated or discharged heat to the outside. In this instance, the copper heat block 510 is composed of or includes a first copper heat plate 511 and a fourth copper heat plate 512. The fourth copper heat plate 512 extends from the first copper heat plate 511 to form side surfaces and an upper surface and makes an airthight inner space with the first copper heat plate 511 so that the coolant 510a is positioned in the airtight inner space.

Specifically, in the third embodiment of the invention, the copper heat block 510 is manufactured by filling the coolant 510a that does not freeze regardless of environmental conditions (that is, antifreeze) in the cooper material and sealing the lower and upper portions and side surfaces. In this instance, the copper heat path 520 and the copper heat fin 530 are sealed also. In addition, the copper heat path 520 may have one of a pipe shape, a plate shape, a polygonal stick shape, or a coil shape, considering the difficulty level of manufacturing or necessity needs. Particularly, in a case that the copper heat path 520 having the pipe shape is used, ends of at least one pairs may be connected to each other to have a "n" shape or a "U" shape, and the coolant 520a may fill in the inside of the pipe. Then, the cooling efficiency can be increased more by the coolant 520a. Thus, the copper heat path 520 may have various shpes for forming a heat path of the copper material. Also, the copper heat fin 530 may be preferably a corrugated fin that can easily adjust or control the size because an installation space is small. In addition, the aluminum heat fin 540 is in close contact with the other surface of the copper heat block 510. The aluminum heat fin 540 may be a plate-shape fin having relatively heat-radiating efficiency. The aluminum heat fin 540 may be formed of or includes an aluminum material. However, the aluminum heat fin 540 is not limited to the aluminum material. That is, the aluminum heat fin 540 may be manufactured by using a mixture material of aluminum and copper in order to enhance thermal conductivity, as necessary. Also, the aluminum may be replaced with a material that can discharge the heat to the outside like the aluminum.

Further, the heat sink apparatus for the exothermic element according to the third embodiment of the invention may further include a second copper heat plate 550 and an aluminum heat fin (or aluminum fins) 560. The second copper heat plate 550 is spaced apart from the copper heat block 510. A supporting hole (or supporting holes) 551 being in close contact and supporting the copper heat path 520 is formed at the second copper heat plate 550. The second copper heat fin 550 disperses the conducted heat. The aluminum heat fin 560 is formed at the second copper heat plate 550, and discharge the dispersed heat to the outside.

By the above structure, the heat generated from the exothermic element 10 is quickly absorbed to one surface (a lower surface of FIG. 11) of the heat block 510. Then, the heat is directly conducted to the coolant 510a through the copper heat block 510. Also, the heat is conducted through the copper heat path 520 in an extended direction (an upward direction of FIG. 11) of the copper heat path 520 and is conducted to the coolant 510a inside copper heat path 520. In this instance, the heat is in contact with the coolant 510a in a large area by the copper heat fin 530, thereby increasing the heat transfer efficiency. The remaining heat that is not cooled by the coolant 510a is conducted to the other surface (an upper surface of FIG. 11) of the copper heat block 510, conducted to the heat fin 540 being in close contact with the other surface of the copper heat block 510, and discharged to the outside.

FIG. 12 is a schematic view illustrating another heat sink apparatus for an exothermic element according to the third embodiment of the invention.

As shown in FIG. 12, another heat sink apparatus for the exothermic element according to the third embodiment of the invention may further include a copper heat coil 570 in order to enhance the cooling efficiency more. One end of the copper heat coil 570 is connected to the copper heat path 520, and is wound from the one end to the other end without contacting.

In addition, the copper heat coil 570 according to the third embodiment of the invention includes a plurality of copper heat coils 570 formed at the other surface of the second copper heat plate 550, along with the copper heat coil 570 formed at the end of the copper heat path 520. A number of the copper heat coils 570 may be varied according to temperature. For example, the number of the copper heat coils 570 may be large when the exothermic element has high temperature, and the number of copper heat coils 570 may be small when the exothermic element has low temperature.

Therefore, the heat sink apparatus for the exothermic element according to the third embodiment of the invention can maximize cooling efficiency of the exothermic elements (for example, electronic devices such as a resistor, an inductor, a capacitor, a semiconductor composing electronics such as a computer and a display device) by the copper heat coil and the heat block. Also, in the heat sink apparatus for the exothermic element according to another embodiment of the invention, a stacked structure or a number of the copper heat coil can be easily changed according to the heat amount from the exothermic element, and thus, the cooling efficiency can be controlled.

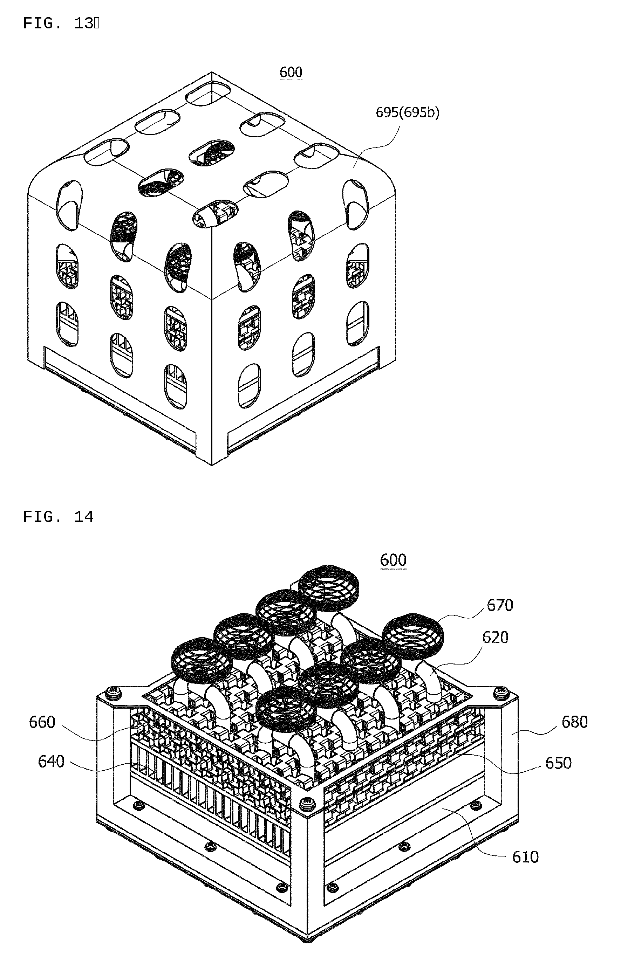

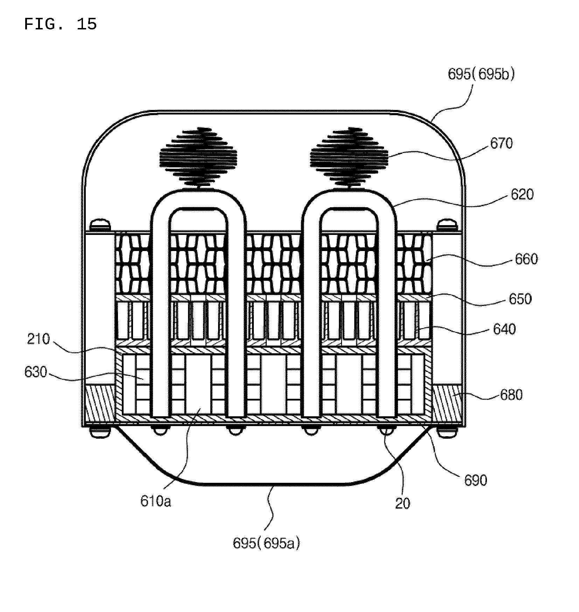

FIG. 13 to FIG. 15 illustrate a heat sink apparatus for an LED device as an example of the heat sink apparatus for the exothermic element according to the third embodiment of the invention. Specifically, FIG. 13 is a perspective view of a heat sink apparatus for an LED device according to the third embodiment of the invention. FIG. 14 is a perspective view of the heat sink apparatus for the LED device in the state that a synthetic-resin LED cover is eliminated, according to the third embodiment of the invention. FIG. 15 is a cross-sectional view the heat sink apparatus for the LED device according to the third embodiment of the invention.

As shown in FIG. 13 to FIG. 15, the heat sink apparatus for the LED device according to the third embodiment of the invention includes a copper heat block 610, a copper heat path (or copper heat paths) 620, a copper heat fin (or copper heat fins) 630, aluminum heat fins 640 and 660, a second copper heat plate (or copper heat plates) 650, a copper heat coil (or copper heat coils) 670, a aluminum case 680, an aluminum LED cover 690, and a synthetic-resin LED cover 695. The heat sink apparatus for the LED device combined with an LED device 20 composes an LED light 600.

In this instance, the heat sink apparatus for the LED device according to the third embodiment of the invention fundamentally includes the copper heat block 610 having a coolant 610a of antifreeze, the copper heat plate 620, the copper heat fin 630, and the aluminum heat fin 640, and thus, immediately absorbes and accumulates heat, and conducts, disperses, and discharges the heat along a path at high speed. Also, since the heat sink apparatus for the LED device further includes the second copper heat plate 650, the aluminum heat fin 660, and the copper heat coil 670, the cooling efficiency can be enhanced more. Detailed descriptions of them may be referred to in the detailed descripitons in the heat sink apparatus for the exothermic element according to the third embodiment of the invention described with reference to FIG 11 and FIG. 12. Thus, the detailed descriptions thereof will be omitted.

In addition, the heat sink apparatus for the LED device further includes the aluminum case 680, the aluminum LED cover 690, and the synthetic-resin LED cover 695, as in the first embodiment of the invention.

The heat sink apparatus for the LED device according to the third embodiment of the invention as in the above can compose a portable LED light being interal with the heat sink apparatus and having high cooling efficiency.

<Fourth Embodiment>

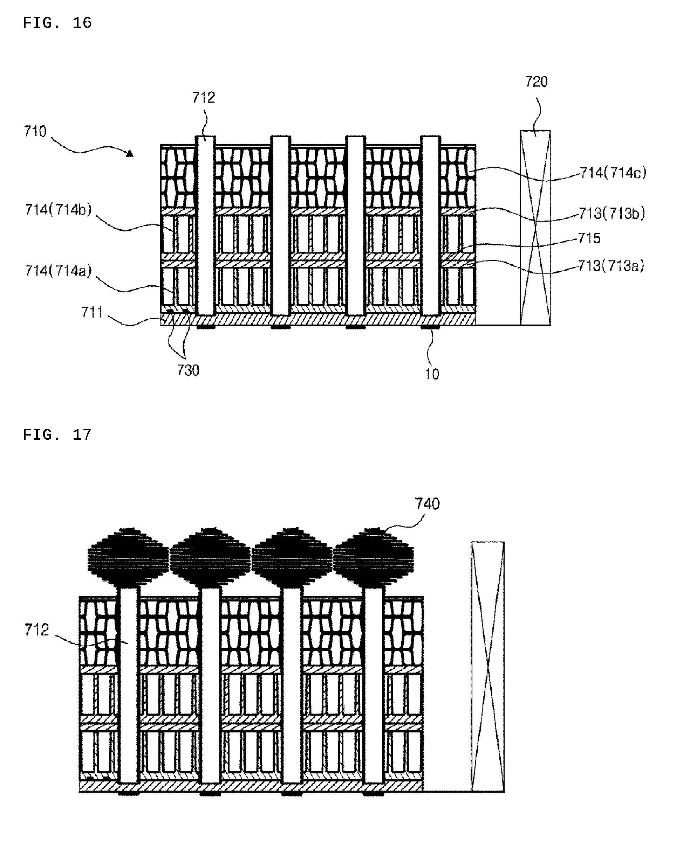

FIG. 16 is a schematic view illustrating a basic structure of a heat sink apparatus for an exothermic element according to a fourth embodiment of the invention.

As shown in FIG. 16, the heat sink apparatus for the exothermic element according to the fourth embodiment of the invention includes a heat block 710, a low-speed cooling fan 720, and a thermostat 730. The heat block 710 is in close contact with the exothermic element 10, and accumulates and discharge the heat of the exothermic element 10 to the outside. The low-speed cooling fan 720 is installed at one side of the heat block 710. The low-speed cooling fan 720 forced-convects the atmosphere and eliminates the dust of the heat block during an operation having an operation time of 25,000 hours or more. The thermostat 730 detects the temperature of the heat block 710. The thermostat 730 operates the low-speed cooling fan 720 when the temperature is the predetermined threshold temperature or more. The thermostat 730 stops the low-speed cooling fan 720 when the temperature is less than the predetermined threshold temperature.

Specifically, the low-speed cooling fan 720 is a cooling fan that can operate for 25,000 hours or more at a low speed. The low-speed cooling fan 720 is attached on a side surface of the heat block 710 and forced-convects the atmosphere. In the instance, the low speed is about a speed that a human blow off. The forced-convection increases the cooling power or the cooling ability of the heat block 710, and induces and increases the vibraton of the copper heat coil (740 of FIG. 17). That is, in the case of the copper heat coil, the forced convection of the low-speed cooling fan 720 is added to the forced convection for vibrating the copper heat coil, thereby inducing the forced convection same as or similar to the force convection of a high-speed cooling fan. The thermostat 730 controls on/off of the low-speed cooling fan 720 according to the predetermined temperature threshold value. The thermostat 730 includes a pair of thermostats 730 to be suitable to cool the heat according to the temperature of the heat block 710 (particularly, to be suitable to cool the heat of the high temperature). In FIG. 16, the thermostat 730 is installed at the heat fin 714 of the heat block 710. The thermostat 730 may be in the heat block 710 or out of the heat block 710. That is, the installation location of the thermostat 730 is not limited if temperature of the heat block 710 can be detected well. In addition, although a shape of the thermostat 730 is blocked and schematically shown in FIG. 16, a substantial shape and a substantial structure of the thermostat 730 may have a general shape and a general structure.

In addition, the low-speed cooling fan 720 increase the cooling power or ability, and also eliminates the dust in order to prevents a decrease in a heat-radiating ability. The decrease in the heat-radiating ability may be induced by depositing the foreign substances such as the dust on surfaces of a heat fin 714 and the heat coil 740 and so on composing the heat block 710. With respect to a function for eliminating the dust, an operation switch may be further included. The operation switch operates the low-speed cooling fan 720 during the predetermined time to have regular intervals. Thus, by the operation switch, the efficiency in the dust elimination can be enhanced, and a life of the low-speed cooling fan 720 can be extended.

Meanwhile, the heat block 710 accumulates the heat of the exothermic element 10 and discharges to the outside. The heat block 710 shown in FIG. 16 includes a first copper heat plate 711, a copper heat path (or copper heat paths) 712, a second copper heat plate (or second copper heat plates) 713, and the heat fin (or heat fins) 714. Thus, the heat block 710 has a structure of the heat sink apparatus for the exothermic element according to the first emebodiemtn of the invention.

FIG. 17 is a schematic view illustrating another heat sink apparatus for an exothermic element according to the fourth embodiment of the invention.

As shown in FIG. 17, another heat sink apparatus for the exothermic element according to the fourth embodiment of the invention may further include a copper heat coil (or copper heat coils) 740, along with elements of the heat sink apparatus for the exothermic element according to the fourth embodiment of the invention. One end of the copper heat coil 740 is connected to the copper heat path 712, and is wound from the one end to the other end without contacting. Accordingly, the cooling efficiency can be enhanced more.

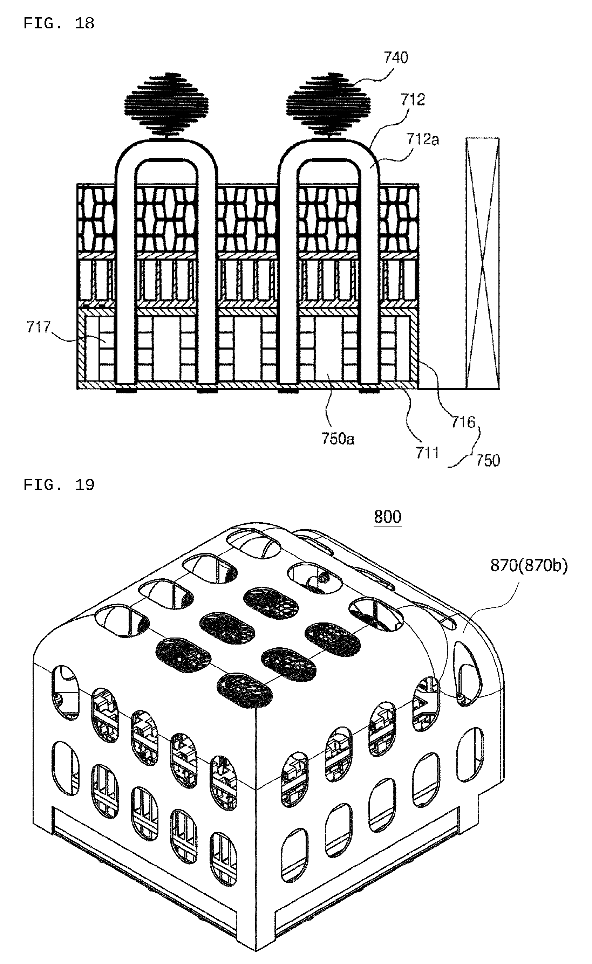

FIG. 18 is a schematic view illustrating yet another heat sink apparatus for an exothermic element according to the fourth embodiment of the invention.

As shown in FIG. 18, the heat sink apparatus for the exothermic element according to yet another embodiment of the invention may further include a fourth copper heat plate 716 and a copper heat fin 717. The fourth copper heat plate 712 extends from the first copper heat plate 711 to form side surfaces and an upper surface and makes an airthight inner space with the first copper heat plate 711 so that a coolant 750a is positioned in the airtight inner space. The copper heat fin 717 is formed at an outer surface of the copper heat path 712 being in contact with the coolant 750a, and conducts the conducted heat of the copper heat path 712 to the coolant 750a.

Therefore, the heat sink apparatus for the exothermic element according to the fourth embodiment of the invention can maximize cooling efficiency of the exothermic elements (for example, electronic devices such as a resistor, an inductor, a capacitor, a semiconductor composing electronics such as a computer and a display device) by the low-speed cooling fan, the copper heat coil, and the heat block. Also, in the heat sink apparatus for the exothermic element according to the embodiment of the invention, an operated state of the low-speed cooling fan, a stacked structure, or a number of the copper heat coil can be easily changed according to the heat amount from the exothermic element, and thus, the cooling efficiency can be controlled.

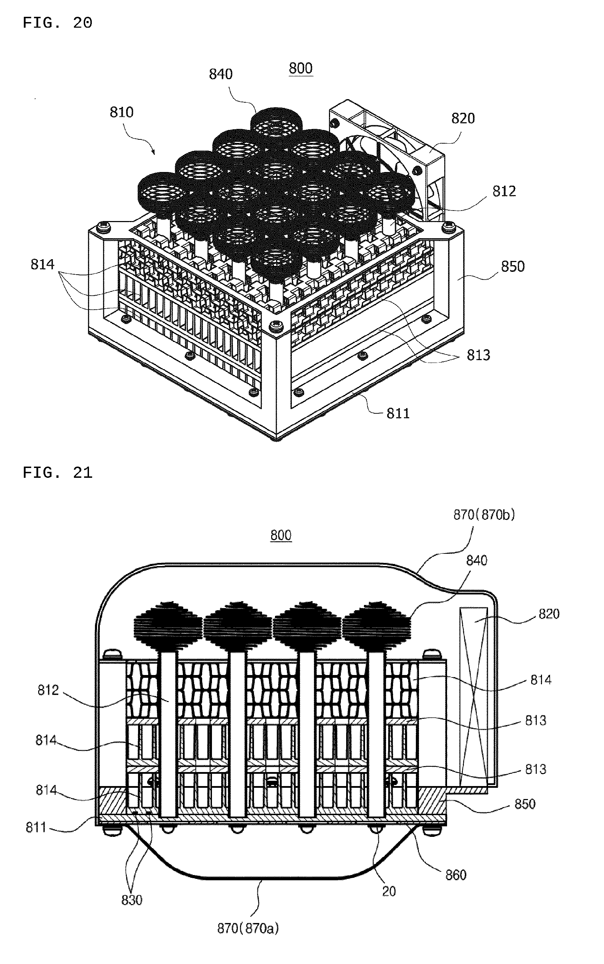

FIG. 19 to FIG. 21 illustrate a heat sink apparatus for an LED device as an example of a heat sink apparatus for an exothermic element according to the fourth embodiment of the invention. Particularly, the heat sink apparatus for the LED device employs the structure the heat block shown in FIG. 17. Specifically, FIG. 19 is a perspective view of a heat sink apparatus for an LED device according to the fourth embodiment of the invention. FIG. 20 is a perspective view of the heat sink apparatus for the LED device in the state that a synthetic-resin LED cover is eliminated, according to the fourth embodiment of the invention. FIG. 21 is a cross-sectional view the heat sink apparatus for the LED device according to the fourth embodiment of the invention.

As shown in FIG. 19 to FIG. 21, the heat sink apparatus for the LED device according to the fourth embodiment of the invention includes a heat block 810, a low-speed cooling fan 820, a thermostat 830, a copper heat coil (or copper heat coils) 840, an aluminum case 850, an aluminum LED cover 860, and a synthetic-resin LED cover 870. The heat sink apparatus for the LED device combined with an LED device 20 composes an LED light 800. The heat block 810 is composed of or includes a first copper heat plate 811, a copper heat path (or copper heat paths) 812, a second copper heat plate (or second copper heat plates) 813, and a heat fin (or heat fins) 814.

In this instance, the heat sink apparatus for the LED device according to the fourth embodiment of the invention fundamentally includes the heat block 810, the low-speed cooling fan 820, and the thermostat 830. Accordingly, cooling efficiency can be effectively enhanced by the forced convection and eliminating dust. Detailed descriptions of them may be referred to in the detailed descriptions in the heat sink apparatus for the exothermic element according to the embodiment of the invention described with reference to FIG 16 to FIG. 18. Thus, the detailed descriptions thereof will be omitted.

In addition, the heat sink apparatus for the LED device further includes the aluminum case 850, the aluminum LED cover 860, and the synthetic-resin LED cover 870, as in the first embodiment of the invention.

The heat sink apparatus for the LED device according to the fourth embodiment of the invention as in the above can compose a portable LED light being interal with the heat sink apparatus and having high cooling efficiency.

<Fifth Embodiment>

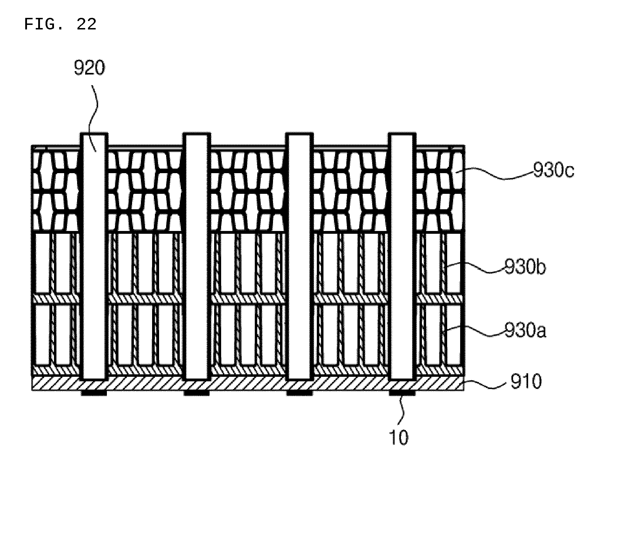

FIG. 22 is a schematic view illustrating a basic structure of a heat sink apparatus for an exothermic element according to a fifth embodiment of the invention.

As shown in FIG. 22, a heat sink apparatus for an exothermic element according to a fifth embodiment of the invention includes a copper heat plate 910, a copper heat path (or copper heat paths) 920, and a heat fin (or heat fins) 930. One surface of the copper heat plate 910 is in close contact with an exothermic element 10. The copper heat plate 910 accumulates the heat of the exothermic element 10. The copper heat path 920 extends from the other surface of the copper heat plate 910 and conducts the accumulated heat in an extended direction of the copper heat path 920. The heat fin 930 is formed at the other surface of the copper heat plate 910 and is in close contact with the copper heat plate 920. The heat fin 930 discharges the heat accumulated at the copper heat plate 910 and conducted along the copper heat path 920 to the outside.

Also, the heat fins 930a, 930b, and 930c may be stacked along the copper heat path 920. That is, in the case that the exothermic element 10 generating heat of high temperature, in the process of conducting the heat generated from the exothermic element 10 far away, the heat is discharged through the heat fins 930a, 930b, and 930c by using a long copper heat path 920 that is a heat path and by continuously stacking the heat fins 930a, 930b, and 930c. Accordingly, the exothermic element 10 can be sufficiently cooled.

Thus, the heat sink apparatus for the exothermic element according to the fifth embodiment of the invention has a structure that the second copper heat plate of the first embodiment of the invention is eliminated. Thus, the best simple structure can be achieved.

<Other Embodiments>

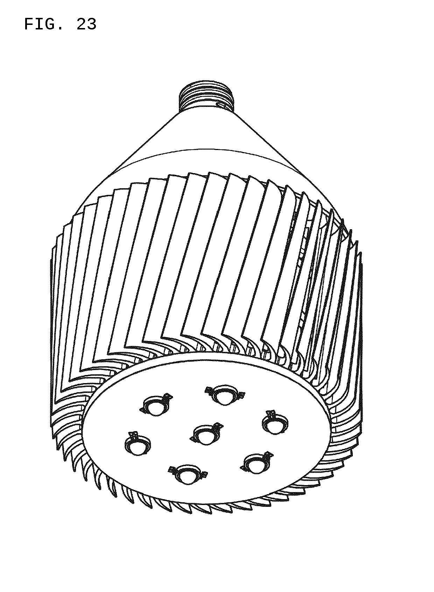

(A) FIG. 23 is a schematic view illustrating a heat sink apparatus for an exothermic element according to anther embodiment of the invention.

As shown in FIG. 23, a part of the heat sink apparatus for the LED device according to another embodiment of the invention may be manufactured to have a sphere shape, like an incandescent light or three wave fluorescent lamp, and to have a socket connector. Accordingly, the heat sink apparatus can be used by connecting a socket of a general light bulb. In this instance, elements of the heat sink apparatus for the LED device may preferably have circular shapes, unlike the elements of the heat sink apparatus for the LED device shown in the above embodiments.

(B) Also, in yet another embodiment of the invention, gold, silver, and so on having thermal conductivity and heat-radiating property superior than those of aluminum may be used instead of copper. That is, the first metal corresponding to the copper is a metal having superior thermal conductivity and heat-accumulating property. Thus, a metal that can easily accumulate and disperse the heat may be preferably used for the first metal. Also, the second metal corresponding to the aluminum has heat-radiating efficiency superior than that of the first metal. Thus, a metal that can discharge the accumulated and dispersed heat to the atmosphere may be preferably used for the second metal. The structure using both the first metal and the second metal may be as in the first to fifth embodiment, thereby maximizing the cooling efficiency.

(C) In embodiments of the invention, although the LED device is exemplified as the exothermic element, the exothermic element of the invention is not limited to the same. For example, the exothermic element may be an exothermic element for information technology (IT) such as a random-access memory (RAM), a diode, a transistor, and so on.

That is, the above technical features of the invention may be achieved through other specific embodiments by skilled person in the art to which the invention pertains without changing the technical features or necessary property

Therefore, the above embodiments are just illustrative, and the invention is not limited thereto. The scope of the invention is represented by the appended claims. Thus, various modifications of the embodiments are possible within the scope of the invention defined by the appended claims.

## Claims

1. A heat sink apparatus for an exothermic element, comprising:
a first copper heat plate for accumulating heat of an exothermic element, wherein one surface of the first copper heat plate being in close contact with the exothermic element;
a copper heat path for conducting the accumulated heat in an extended direction of the copper heat path, wherein the copper heat path extending from the other surface of the first copper heat plate;
a second copper heat plate for dispersing the conducted heat, wherein one surface of the second copper heat plate being spaced apart from the other surface of the first copper heat plate and the second copper heat plate including a supporting hole, wherein the supporting hole being in close contact with and supporting the copper heat path; and
a heat fin for discharging the accumulated or discharged heat to the outside, wherein the heat fin being formed at the other surface of the first copper heat plate and the other surface of the second copper heat plate.

2. The heat sink apparatus for the exothermic element according to claim 1, further comprising: a third copper heat plate partially or entirely seals side surfaces of the first copper heat plate, the second copper heat plate, and the heat fin.

3. The heat sink apparatus for the exothermic element according to claim 1, further comprising:
at least one copper heat coil,
wherein one end of the copper heat coil is connected to the extended end of the copper heat path or the other surface of the second copper heat plate,
the copper heat coil is wound from the one end to the other end without contacting, and
the copper heat coil conducts the accumulated or discharged heat to the other end, vibrates by a temperature difference with the atmosphere, and discharges the heat to the outside by forced convection.

4. The heat sink apparatus for the exothermic element according to claim 3, wherein the copper heat coil has a wound coil shape or a wound plate shape.

5. The heat sink apparatus for the exothermic element according to claim 1, further comprising:
a fourth copper heat plate extended from the first copper heat plate to form side surfaces and an upper surface, wherein the fourth copper heat plate makes an airtight inner space where a coolant is positioned; and
a copper heat fin formed at an outer surface of the copper heat path being in contact with the coolant and conducting the conducted heat from the copper heat path to the coolant.

6. The heat sink apparatus for the exothermic element according to claim 5, wherein the coolant is antifreeze.

7. The heat sink apparatus for the exothermic element according to claim 5, wherein the copper heat path has a pipe shape having at least a pair of ends connected to each other and being filled with the coolant.

8. The heat sink apparatus for the exothermic element according to claim 1, further comprising:
a low-speed cooling fan installed at one side of a heat block the first copper heat plate, the copper heat path, the second copper heat plate, and the heat fin, wherein the low-speed cooling fan forced-convecting the atmosphere and eliminating dust of the heat block during an operation having an operation time of 25,000 hours or more; and
a thermostat detecting temperature of the heat block, wherin the thermostat operting the low-speed cooling fan when the temeprature is the predetremined threshold temperature or more and stopping the low-speed cooling fan when the temeprature is less than the predetremined threshold temperature.

9. The heat sink apparatus for the exothermic element according to claim 1, wherein the copper heat path has one of a pipe shape, a plate shape, a polygonal stick shape, or a coil shape.

10. The heat sink apparatus for the exothermic element according to claim 1, wherein the second copper heat plate comprises at least two second copper heat plates spaced apart from each other in the extended direction of the copper heat path, and
the heat fin comprises at least two heat fins formed at the at least two second copper heat plates, respectively.

11. The heat sink apparatus for the exothermic element according to claim 1, wherein the heat fin comprises an aluminum material and a mixture material of aluminum and copper.

12. The heat sink apparatus for the exothermic element according to claim 1, wherein the heat fin comprises a plate-shape fin or a corrugated fin.

13. The heat sink apparatus for the exothermic element according to claim 1, further comprising:
an aluminum case supporting the first copper heat plate, the copper heat path, the second copper heat plate, and the heat fin,
wherein the aluminum case has an open type or a close type.

14. The heat sink apparatus for the exothermic element according to one of claims 1 to 13, wherein the exothermic element is at least one of a light emitting diode (LED) device or an exothermic element for information technology (IT).

15. The heat sink apparatus for the exothermic element according to claim 14, further comprising:
an aluminum LED cover fixing and supporting the LED device, and
a synthetic-resin LED cover surrounding the LED device to an outermost cover and protecting the LED device.

16. A heat sink apparatus for an exothermic element, comprising:
a first heat plate for accumulating heat of an exothermic element, wherein one surface of the first heat plate being in close contact with the exothermic element, wherein the first heat plate comprising a first metal material;
a heat path for conducting the accumulated heat in an extended direction of the heat path, wherein the heat path extending from the other surface of the first heat plate, wherein the heat path comprising the first metal material;
a second heat plate for dispersing the conducted heat, wherein one surface of the second heat plate being spaced apart from the other surface of the first heat plate and the second heat plate including a supporting hole, wherein the supporting hole being in close contact with and supporting the heat path, wherein the second heat plate comprising the first metal material; and
a heat fin for discharging the accumulated or discharged heat to the outside, wherein the heat fin being formed at the other surface of the first heat plate and the other surface of the second heat plate, wherein the heat fin comprising a second metal material having heat-radiating efficiency higher than that of the first metal material.

17. The heat sink apparatus for the exothermic element according to claim 16, wherein the second metal material comprises an aluminum material and a mixture material of aluminum and copper, and
the first metal material comprises gold, silver, or copper having thermal conductivity and heat-accumulating property superier than those of the second metal material.
